# FASCICULE DE BREVET EUROPEEN

(11) **EP 0 600 810 B1**
(45) Date de publication et mention de la délivrance du brevet: **09.06.1999**
(21) Numéro de dépôt: 93420475.1
(22) Date de dépôt: 29.11.1993
(51) Int. Cl.: H01L 27/02

(54) **Dispositif de protection contre des surtensions**
Überspannungsschutzeinrichtung
Overvoltage protection device

(30) Priorité: 04.12.1992 FR 9214793
(43) Date de publication de la demande: 08.06.1994
(73) Titulaire: STMicroelectronics S.A., 94250 Gentilly (FR); STMicroelectronics, Inc., Carrollton, TX 75006-5039 (US)
(72) Inventeur: Pezzani, Robert, F-37210 Vouvray (FR); Ugge, Angelo, Plano, Texas 75024-6300 (US)
(74) Mandataire: de Beaumont, Michel

(56) Documents cités:
- EP-A- 0 472 405
- WO-A-87/06768
- FR-A- 2 453 522
- GB-A- 2 184 884
- US-A- 4 282 555
- US-A- 4 905 119

## Description

La présente invention concerne de façon générale des circuits de protection pour dispositifs électroniques et plus particulièrement des circuits de protection contre des surtensions adaptés à être utilisés dans des dispositifs de protection liés à des lignes téléphoniques.

Pour empêcher des endommagements dus à des surtensions électriques, des dispositifs liés à des lignes électriques telles que des lignes téléphoniques sont protégés par des circuits de protection contre des surtensions conçus pour cette tâche. Ces surtensions peuvent par exemple être provoquées par la foudre quelque part dans le système ou des pointes de puissance provoquées par une mise en contact accidentelle avec une ligne du réseau électrique. Les circuits de protection contre des surtensions doivent protéger les dispositifs et se rebloquer pour permettre un fonctionnement normal après la fin de la surtension.

Dans l'art antérieur, de nombreux types de circuits ont été utilisés pour assurer une protection. Typiquement, ces circuits utilisent deux ou trois dispositifs discrets à semiconducteurs placés dans un boîtier commun. Ces dispositifs peuvent assurer une bonne protection mais l'utilisation de plus d'une puce semiconductrice dans un boîtier conduit à un circuit de protection relativement coûteux.

Des circuits de protection contre des surtensions destinés à être utilisés avec un équipement téléphonique doivent tenir compte des risques particuliers que l'on rencontre quand les dispositifs sont connectés au réseau téléphonique. Deux lignes de signal incidentes appelées, pour des raisons historiques, "pointe" et "bague" (d'après les termes anglo-saxons "tip" et "ring"), transportent le signal téléphonique normal. Des surtensions peuvent survenir entre ces deux lignes. De façon plus courante, les surtensions peuvent survenir entre une ou deux de ces lignes et la masse. En fonctionnement normal, la tension des lignes de pointe et de bague flotte par rapport à la masse bien qu'une ligne soit typiquement à approximativement -2 volts et l'autre à approximativement -50 volts. Il existe normalement une tension différentielle de 48 volts entre les deux lignes.

Pour assurer la protection la plus complète possible, il faut assurer une protection contre des surtensions entre les lignes de pointe et de bague ainsi qu'entre ces lignes et la masse. Ainsi, dans la plupart des applications, on préfère un circuit de protection équilibré à trois voies bien que des circuits à deux voies trouvent des utilisations et soient courants dans la technique. Des exemples de dispositifs utilisés pour assurer la protection requise sont donnés dans les brevets des Etats-Unis d'Amérique 4 282 555 et 4 905 119.

Bien que les circuits décrits dans ces brevets puissent assurer une protection convenable à des dispositifs liés à des lignes téléphoniques, ils sont difficiles à fabriquer à faible coût sous forme d'un circuit intégré monolithique. Le circuit du brevet 4 905 119 utilise plus d'une puce, ce qui augmente le coût du circuit d'ensemble. Le dispositif décrit dans le brevet 4 282 555 peut être réalisé sur une puce unique mais on doit utiliser des diffusions profondes de type P qui traversent le dispositif dans un but d'isolation. Ce processus augmente beaucoup le coût du dispositif.

Un objet de la présente invention est de prévoir un circuit de protection contre des surtensions qui puisse être intégré facilement et à faible coût sous forme d'un dispositif monolithique unique.

Un autre objet de la présente invention est de prévoir un tel circuit qui se rebloque de façon satisfaisante dans le cas d'une liaison à une ligne téléphonique.

Un autre objet de la présente invention est de prévoir un tel circuit qui se déclenche non seulement par suite d'une surtension mais aussi par suite d'une surintensité.

Un autre objet de la présente invention est de prévoir un tel circuit qui soit suffisamment flexible pour être facilement modifié pour satisfaire à plusieurs modes de protection différents.

Un autre objet de la présente invention est de prévoir un tel circuit qui incorpore des modes de mise en boîtier qui soient flexibles et facilement adaptés à différentes exigences de montage et de dissipation thermique.

En conséquence, selon la présente invention, une structure de circuit de protection contre des surtensions peut être utilisée pour fabriquer plusieurs circuits différents incorporant des techniques de protection différentes. La structure se prête à être utilisée sous forme d'un dispositif unique qui peut facilement et à faible coût être mis en boîtier et protégé de l'environnement. Des circuits de protection à trois bornes peuvent comprendre trois bornes sur la surface supérieure d'un substrat ou une borne sur la surface inférieure du substrat, en utilisant une structure modulaire unique. Des circuits supplémentaires peuvent être inclus pour détecter des conditions de surintensité qui sont provoquées par des surtensions trop faibles pour déclencher les circuits normaux de protection contre des surtensions.

Plus particulièrement, la présente invention prévoit un circuit de protection contre des surtensions tel que défini en revendication 1.

Selon un mode de réalisation de la présente invention, la cinquième région est formée sur une surface du substrat opposée à celle des première et deuxième régions, d'où il résulte que des commutateurs bidirectionnels forment une configuration en triangle.

Selon un mode de réalisation de la présente invention, les première, deuxième et cinquième régions sont formées sur une même surface du substrat, d'où il résulte que les commutateurs bilatéraux forment une configuration en triangle.

Selon un mode de réalisation de la présente invention, un noeud commun conducteur est formé sur une deuxième surface du substrat opposée à ladite même surface.

Selon un mode de réalisation de la présente invention, le noeud commun conducteur comprend une couche métallique formée sur la deuxième surface du substrat.

Selon un mode de réalisation de la présente invention, le premier type de conductivité est le type N et le deuxième type de conductivité est le type P.

Selon un mode de réalisation de la présente invention, le circuit de protection contre des surtensions comprend en outre des premier et deuxième détecteurs connectés électriquement aux premier et deuxième contacts pour détecter un passage de courant à travers les lignes de signal connectées aux premier et deuxième contacts ; et des premier et deuxième circuits connectés auxdits détecteurs pour relier électriquement les premier et deuxième contacts ensemble quand la circulation de courant détectée dépasse un seuil choisi.

Selon un mode de réalisation de la présente invention, les premier et deuxième détecteurs comprennent des résistances.

Selon un mode de réalisation de la présente invention, les premier et deuxième circuits comprennent des thyristors.

Selon un mode de réalisation de la présente invention, les détecteurs et les circuits fonctionnent pour un courant circulant dans une première direction et comprennent en outre des troisième et quatrième détecteurs électriquement connectés aux premier et deuxième contacts pour détecter une circulation de courant dans les lignes de signal dans une seconde direction ; et des troisième et quatrième circuits connectés aux troisième et quatrième détecteurs pour connecter électriquement les premier et deuxième contacts l'un à l'autre quand la circulation de courant détectée dans la seconde direction dépasse le seuil choisi.

Selon un mode de réalisation de la présente invention, les détecteurs et les circuits sont formés dans lesdites première et deuxième régions, formant ainsi un circuit intégré monolithique.

Selon un mode de réalisation de la présente invention, des conducteurs sont connectés aux premier, deuxième et troisième contacts.

Selon un mode de réalisation de la présente invention, les conducteurs s'étendent à l'extérieur d'un boîtier isolant contenant le substrat.

Selon un mode de réalisation de la présente invention, un radiateur est connecté au troisième contact.

Selon un mode de réalisation de la présente invention, le noeud commun est connecté à un radiateur externe à un boîtier contenant le substrat.

Selon un mode de réalisation de la présente invention, les sous-régions des troisième, quatrième et sixième régions sont circulaires.

Ces objets, caractéristiques et avantages ainsi que d'autres de la présente invention seront exposés en détail dans la description suivante de modes de réalisation particuliers faite en relation avec les figures jointes parmi lesquelles :
les figures 1A à 1C représentent divers schémas de circuits de protection contre des surtensions ;
les figures 2A et 2B sont respectivement une vue de dessus et une vue de dessous d'un dispositif selon la présente invention ;
les figures 3A et 3B sont des vues en coupe du dispositif de la figure 2 ;
la figure 4 est une vue de dessus d'une variante de dispositif selon la présente invention ;
la figure 5 est une vue en coupe du dispositif de la figure 4 ;
les figures 6A et 6B sont deux schémas de circuit d'autres modes de réalisation de la présente invention ;
les figures 7A et 7B sont des vues de dessus et de dessous d'un dispositif selon les figures 2 et 3 incorporant les schémas des figures 6A et 6B ;
la figure 8 est une vue en coupe du dispositif de la figure 7 ;
la figure 9 est une vue de dessus d'un dispositif selon les figures 4 et 5 incorporant les schémas des figures 6A et 6B ;
la figure 10 est une vue en coupe du dispositif de la figure 9 ;
les figures 11 et 12 illustrent des techniques de mise en boîtier de dispositifs de protection contre des surtensions selon la présente invention ; et
les figures 13A et 13B représentent deux variantes de techniques de mise en boîtier selon la présente invention.

La présente invention peut être mise en oeuvre en utilisant des techniques classiques de fabrication de circuit intégré. Les figures représentant des vues en coupe ou des vues de dessus de circuit intégré ne sont pas tracées à l'échelle mais certaines de leurs parties sont arbitrairement dilatées ou rétrécies pour mieux montrer les caractéristiques importantes de l'invention.

Les dispositifs décrits ci-après concernent des circuits de protection contre des surtensions propres à être utilisées avec un équipement lié à une ligne téléphonique usuelle. Toutefois, l'homme de l'art notera que les dispositifs et les techniques décrits ici peuvent être utilisés sans modification dans certains cas pour servir d'interface entre un équipement électronique et d'autres types de lignes électriques.

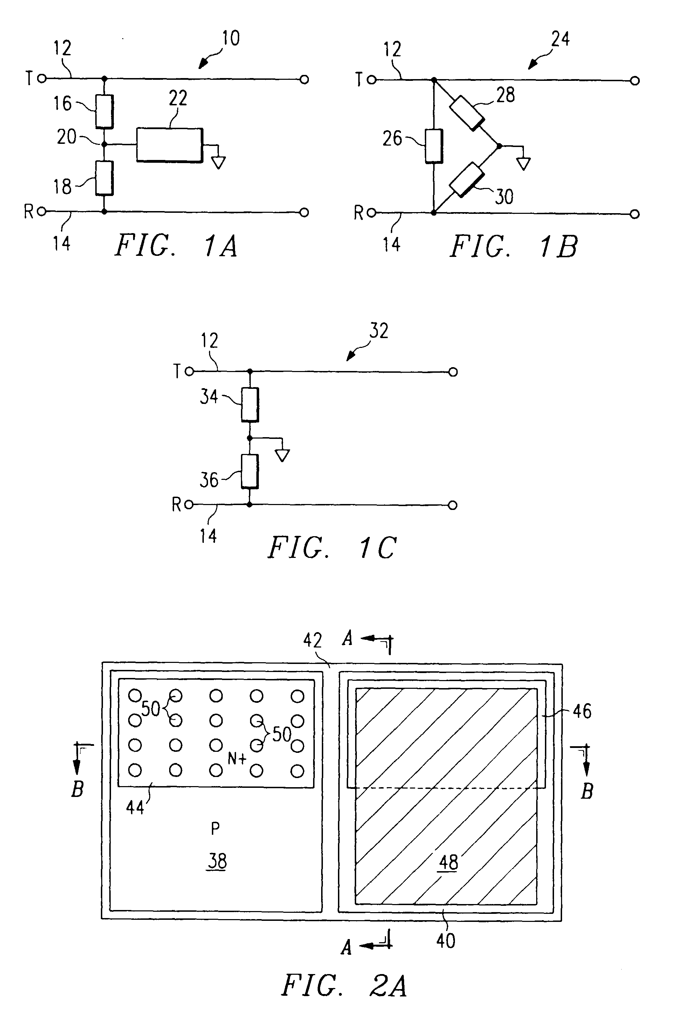

Les figures 1A, 1B et 1C illustrent trois variantes de circuits de protection d'un équipement électronique par rapport à des surtensions apparaissant sur une ligne téléphonique.

En figure 1A, un circuit 10 de protection contre des surtensions est connecté entre des conducteurs de pointe (T) et de bague (R), 12 et 14 respectivement. Deux dispositifs de protection contre des surtensions 16 et 18 sont connectés respectivement aux conducteurs de pointe et de bague et à un noeud commun 20. Un troisième dispositif de protection 22 est connecté entre le noeud commun 20 et la masse.

De façon connue, la combinaison en série des dispositifs de protection 16 et 18 devient passante pour court-circuiter les lignes 12 et 14 quand une différence de tension importante survient entre ces lignes. Si un potentiel important apparaît entre les lignes 12 et 14 et la masse, les trois dispositifs de protection 16, 18 et 22 commencent à conduire et dirigent le courant vers la masse. De plus, chacun des dispositifs 16, 18, 22 doit cesser de conduire quand la surtension cesse.

Chacun des dispositifs de protection 16, 18 et 22 se déclenche pour une tension qui est la moitié de la tension de protection souhaitée. Par exemple, si on souhaite déclencher les circuits de protection pour une surtension de 500 volts ou plus, chacun des dispositifs de protection 16, 18 et 22 se déclenchera pour 250 V. Ainsi, si une différence de 500 V apparaît entre les lignes 12 et 14, les dispositifs de protection 16 et 18 entreront en conduction. S'il apparaît un potentiel de 500 V ou plus entre chacune des lignes 12 ou 14 et la masse, le dispositif de protection approprié 16 ou 18 sera déclenché ainsi que le dispositif de protection 22.

De façon connue, l'une des causes les plus courantes de surtension réside dans les coups de foudre. Ces surtensions provoquent typiquement une différence de tension importante entre chacune des lignes de pointe et de bague et la masse. En ce cas, les trois dispositifs de protection 16, 18 et 22 conduiront simultanément. Puisque la différence de tension entre les lignes de pointe et de bague est faible en comparaison de la surtension correspondant à un coup de foudre, les courants circulant dans chacun des dispositifs de protection 16 et 18 sont sensiblement égaux. Ceci entraîne que le dispositif de protection 22 doit conduire deux fois plus de courant vers la masse que le courant qui circule dans chacun des dispositifs de protection 16, 18. En figure 1A, ceci est indiqué par la dimension plus grande du bloc figurant le dispositif de protection 22.

La figure 1B représente une variante de circuit de protection contre des surtensions 24 utilisé avec les mêmes lignes de pointe et de bague 12 et 14. Le circuit 24 est disposé en triangle et non pas en étoile comme le circuit de la figure 1A. Le circuit de protection 24 contient trois dispositifs de protection 26, 28, 30. Dans la configuration en triangle, chacun des dispositifs de protection 26, 28, 30 est conçu pour se déclencher à la tension de protection désirée et non pas à la moitié de la tension de protection désirée comme dans le cas de la figure 1A. Chaque branche de la configuration en triangle est susceptible de conduire le même courant bien que, comme cela a été décrit ci-dessus, la situation de surcharge la plus courante corresponde à une surtension simultanée sur les lignes de pointe et de bague par rapport à la masse. Dans ce cas, les deux dispositifs de protection 28 et 30 conduiront sensiblement le même courant vers la masse.

La figure 1C représente un troisième circuit de protection contre des surtensions 32 qui est déséquilibré par rapport aux deux circuits précédemment décrits. Les dispositifs de protection 34 et 36 sont tous deux connectés directement à la masse. Ce circuit assure une protection convenable contre des surtensions en mode commun telles que celles provoquées par des coups de foudre mais nécessite une surtension deux fois plus grande pour provoquer une mise en conduction entre les lignes 12 et 14. Toutefois le circuit de la figure 1C présente de nombreuses utilisations pratiques quand on veut essentiellement se protéger contre des surtensions par rapport à la masse et non pas entre les deux conducteurs de la ligne téléphonique.

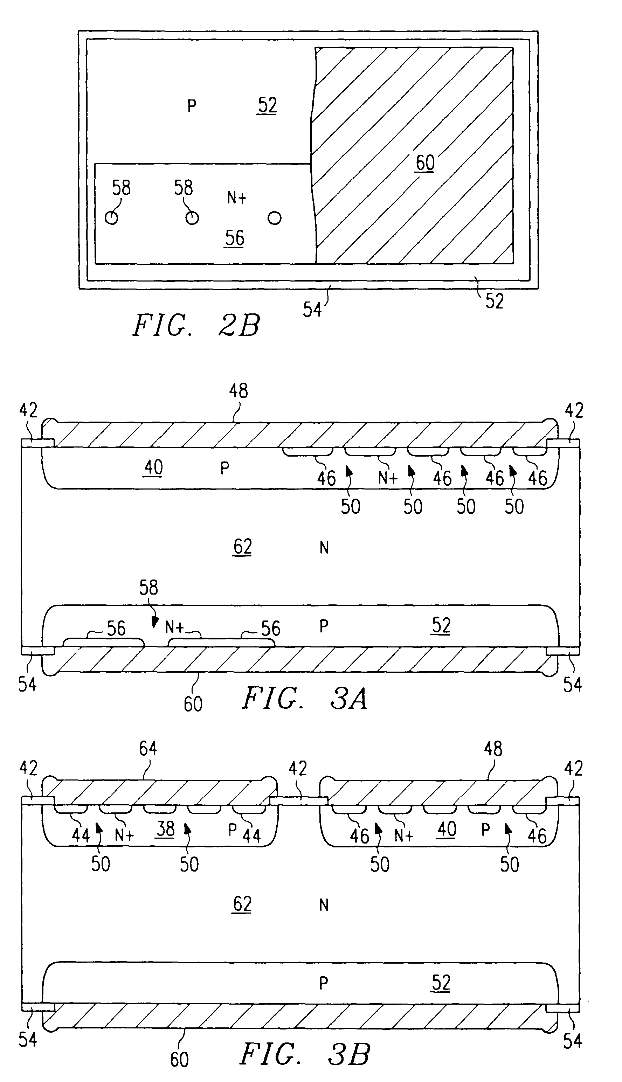

Les figures 2A et 2B représentent respectivement des vues de dessus et de dessous d'un dispositif semiconducteur monolithique propre à être utilisé comme circuit de protection contre des surtensions. Le mode de réalisation représenté en figure 2 met en oeuvre le circuit de protection 24 de la figure 1B. Chacun des dispositifs de protection représenté en figure 1B est un commutateur bidirectionnel PNPN. Comme le représente la figure 2A, le dispositif de protection comprend deux caissons P 38, 40. Les caissons P 38, 40 sont formés sur la surface supérieure d'un substrat et leurs régions d'affleurement sont recouvertes d'une couche d'oxyde 42 qui s'étend à la périphérie et entre les caissons. Dans chaque caisson P 38, 40 est formée une région N fortement dopée (N⁺) 44, 46. Un contact métallique 48 recouvre la région de caisson P 40 et la région N⁺ 46. Un contact métallique similaire est formé sur le caisson P 38 et la région N⁺ 44 mais n'est pas représenté en figure 2A par souci de clarté d'illustration.

Les régions N⁺ 44 et 46 sont conformées de façon à ne pas être continues. Des régions circulaires 50 du caisson P 38 sous-jacent remontant à travers la région N⁺ 44 sont représentées. Ces régions sont masquées par rapport à l'implantation du dopant N⁺ en utilisant des techniques de masquage connues.

Comme le représente la figure 2B, un caisson P 52 occupe sensiblement toute la surface inférieure du dispositif et sa surface d'affleurement est revêtue d'une région d'oxyde périphérique 54. Une région N⁺ 56 est formée pour couvrir environ la moitié du caisson P 52 et contient des régions circulaires 58 à travers lesquelles on voit le caisson P sous-jacent 52. La région N⁺ 56 est, en projection, sensiblement complémentaire des régions N⁺ 44 et 46 formées du côté de la face supérieure. Un contact métallique 60 recouvre sensiblement tout le caisson P 52 et est représenté en écorché pour montrer la surface du silicium du côté gauche du dispositif.

La figure 3A est une vue en coupe selon la ligne A-A de la figure 2A. Le caisson P et les régions N⁺ portent les mêmes références qu'en figure 2A. On peut voir que les caissons P 40 et 52 sont formés dans un substrat N 62. Les surfaces d'affleurement périphériques des caissons P sont passivées au niveau des surfaces supérieure et inférieure du dispositif par des couches d'oxyde 42, 54.

La structure d'un commutateur bidirectionnel PNPN apparaît à partir de la vue en coupe de la figure 3A. Chacun comprend un premier et un deuxième commutateur PNPN. Le premier commutateur PNPN comprend le caisson P 40, le substrat N 62, le caisson P 52 et la région N⁺ 56. Le deuxième commutateur PNPN en parallèle est constitué du caisson P 52, du substrat N 62, du caisson P 40 et de la région N⁺ 46.

La figure 3B est une vue en coupe du dispositif de la figure 2A prise selon la ligne B-B. La figure 3B comprend un contact métallique 64 qui a été enlevé de la figure 2A pour en clarifier la représentation.

En plus des commutateurs bidirectionnels PNPN verticaux décrits en relation avec la figure 3A, un commutateur bidirectionnel PNPN horizontal est formé entre le contact 64 et le contact 48. Ce commutateur bidirectionnel horizontal comprend un premier commutateur constitué du caisson P 38, du substrat N 62, du caisson P 40 et de la région N⁺ 46, et un deuxième commutateur constitué du caisson P 40, du substrat N 62, du caisson P 38 et de la région N⁺ 44.

Ainsi, quand une différence de tension suffisante survient entre les lignes de pointe et de bague, un courant circule entre le contact 64 et le contact 48. Quand une surtension apparaît entre les deux lignes de pointe et de bague et la masse, le courant circule verticalement à travers le dispositif à partir des contacts 64 et 48 vers le contact 60 qui est relié à la masse. La grande surface du contact de masse 60 permet d'éviter une surchauffe due à la circulation de courants élevés vers la masse. Puisque les courants liés aux surtensions entre pointe et bague tendent à être notablement moindres, la plus faible capacité de tenue en courant du dispositif entre les contacts 64 et 48 est suffisante.

Selon un aspect de la présente invention, les commutateurs PNPN bidirectionnels qui assurent une conduction verticale à travers le dispositif vers le contact de masse 60 ne fonctionnent pas symétriquement. En effet, la densité d'ouvertures 50 prévues à travers les régions N⁺ 44 et 46 vers les caissons P sous-jacents 36 et 38 est supérieure (par exemple 2 à 5 fois supérieure) à la densité d'ouvertures 58 prévues dans la région N⁺ 56 du côté de la face arrière du dispositif. Le plus grand nombre d'ouvertures 50 pour les contacts prévus du côté supérieur augmente le courant de maintien requis pour maintenir ces dispositifs passants dans le sens direct. Le plus petit nombre d'ouvertures du côté du contact de masse de la face arrière définit un plus petit courant de maintien mais assure une plus forte capacité de tenue en tension. Le rapport du nombre d'ouvertures est supérieur à deux. Ce rapport peut être choisi de façon souhaitée, pour obtenir des rapports de courant de maintien désirés dans les deux directions.

Comme cela est connu de l'homme de métier, les commutateurs de protection déclenchés par une surtension positive sur les conducteurs de pointe et/ou de bague (courant circulant d'un conducteur vers la masse) se bloquent par suite de l'application d'une polarité inverse après que la perturbation cesse, cette polarité inverse étant appliquée par la polarisation négative stable de chaque ligne par rapport à la masse. Toutefois, en sens inverse, quand le courant circule de la masse vers les conducteurs de pointe et de bague, une plus grande valeur du courant de maintien est requise. Cette valeur plus élevée est destinée à assurer que les dispositifs de protection se bloqueront pour permettre un fonctionnement normal de la ligne après une surtension en dépit de la polarisation négative de chacune des lignes par rapport à la masse. Ainsi, avec les commutateurs asymétriques illustrés en figures 2 et 3, le dispositif se rebloque convenablement quelle que soit la polarité de la surtension.

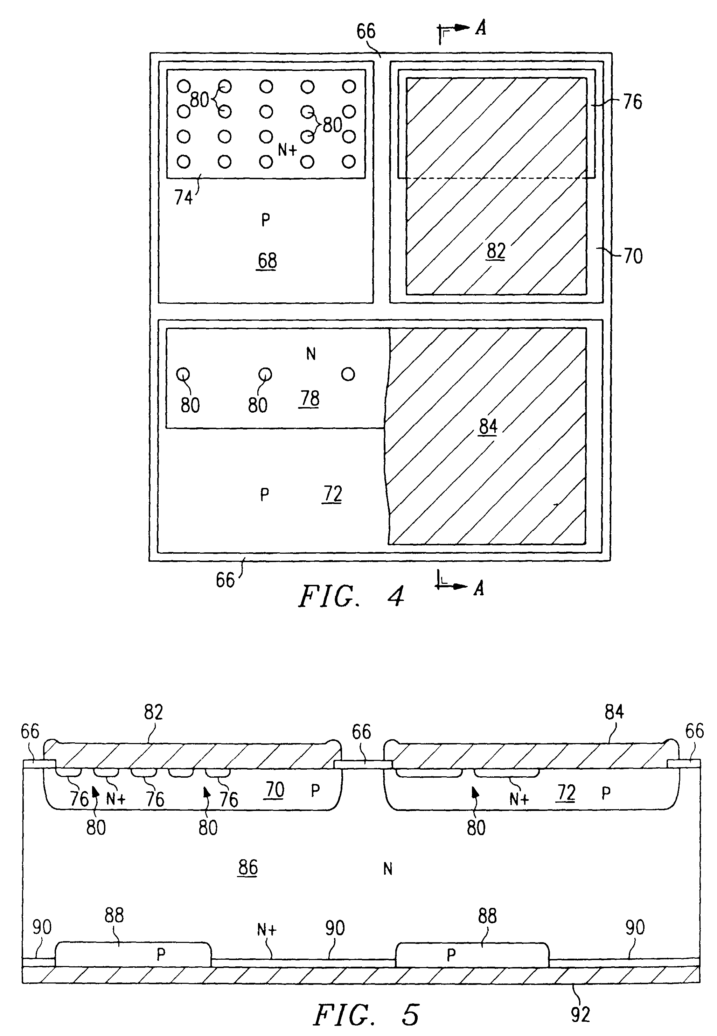

La figure 4 représente en vue de dessus un dispositif de protection qui met en oeuvre le circuit en étoile de la figure 1A. Dans ce cas, les trois contacts sont formés sur la surface supérieure du dispositif. Une région d'oxyde 66 entoure le dispositif et le divise en trois régions. Chacune de ces régions contient un caisson P 68, 70, 72. Le caisson P 68 contient une région N⁺ 74, le caisson P 70 contient une région N⁺ 76 et le caisson P 72 contient une région N⁺ 78. Les divers caissons P présentent à travers leurs régions N⁺ respectives des ouvertures circulaires 80. Les contacts métalliques 82 et 84 recouvrent sensiblement leurs régions P respectives. Comme dans le cas de la figure 2A, le contact métallique sur la région P 68 n'a pas été représenté et le contact métallique 84 a été interrompu pour la clarté de la représentation.

On notera que les diverses régions du dispositif de la figure 4 sont pratiquement identiques aux régions correspondantes des figures 2A et 2B. En fait, en réarrangeant les masques utilisés pour former le dispositif, les mêmes structures peuvent être formées dans le dispositif de la figure 4 que celles qui ont été utilisées dans celui de la figure 2A.

La figure 5 est une vue en coupe du dispositif selon la ligne A-A de la figure 4. Le dispositif est formé dans un substrat N 86. Des régions P 88 et des régions N⁺ 90 sont formées sur la face arrière du substrat 86 et sont connectées par une région conductrice de face arrière 92. La région conductrice 92 peut prendre la forme d'un contact métallique sur la face arrière du dispositif et représente le noeud commun 20 de la configuration en étoile de la figure 1A. Ainsi, la région conductrice 92 n'est normalement pas liée à un contact externe du boîtier. La région conductrice 92 peut être montée sur un radiateur pour dissiper la chaleur produite par le dispositif.

Le dispositif représenté en figures 4 et 5 fonctionne de façon très similaire à celui des figures 2 et 3. La différence est que le courant qui va des connexions de pointe et de bague à la masse circule verticalement vers la face arrière du dispositif, passe par la région de contact conductrice 92 et remonte verticalement vers un autre contact. Un certain courant latéral surviendra également de façon naturelle. Le mode primaire de conduction se fait par les commutateurs PNPN verticaux.

La configuration de la figure 4 fournit un contact de masse qui a une surface deux fois supérieure à celle des contacts de pointe et de bague. Ceci assure une capacité de transport de courant deux fois plus élevée vers le contact de masse, ce qui est souvent requis comme cela a été décrit ci-dessus. Le positionnement des contacts de pointe et de bague adjacent l'un à l'autre permet de bonnes propriétés conductrices entre ces deux bornes. Les contacts de pointe et de bague sont symétriques par rapport au contact de masse, de sorte que les propriétés des commutateurs bidirectionnels PNPN sont les mêmes.

Les circuits décrits ci-dessus assurent une protection contre des surcharges brèves à forte tension/fort courant telles que des coups de foudre. Un autre type de surcharge qui peut survenir produit de plus faibles tensions et courants mais dure typiquement plus longtemps. Ce type de problème peut par exemple résulter d'une surcharge qui survient quand une ligne d'alimentation à 50 hertz touche la ligne de pointe ou de bague. Bien que la tension et le courant qui sont produits soient plus faibles, une telle liaison durable peut en fait transférer plus de puissance qu'un coup de foudre dans l'équipement connecté à la ligne.

La tension imposée sur la ligne par un tel défaut peut ne pas être suffisamment élevée pour déclencher les commutateurs PNPN des dispositifs précédemment décrits. Pour assurer une protection contre ce type de problème à plus faible tension, des circuits supplémentaires peuvent être ajoutés au dispositif précédemment décrit.

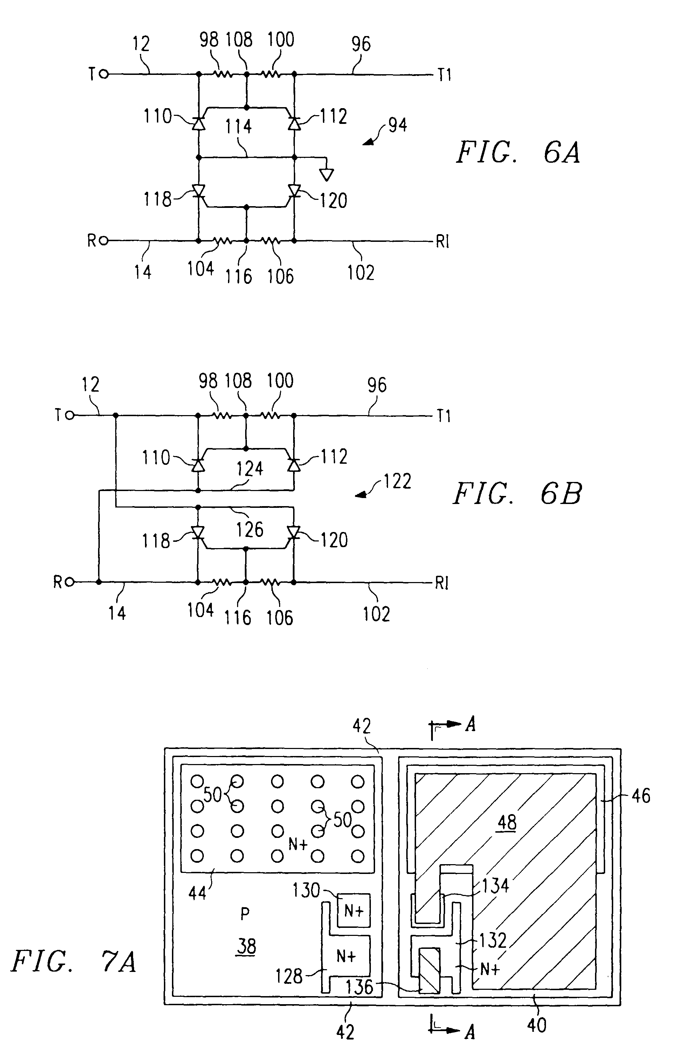

Les figures 6A et 6B représentent deux variantes de circuits qui peuvent être connectées aux conducteurs de pointe et de bague en plus des circuits de protection précédemment décrits.

La figure 6A représente un premier mode de réalisation d'un circuit de protection 94 contre une surcharge. Le conducteur de pointe 12 est relié à une ligne T1 96 par l'intermédiaire de résistances 98, 100. De façon similaire, le conducteur de bague 14 est relié à un conducteur R1 102 par l'intermédiaire de résistances 104, 106. Les bornes T1 et R1 96, 102 sont connectées aux entrées de pointe et de bague de l'équipement à protéger.

Un noeud commun 108 entre les résistances 98 et 100 est connecté à la gâchette de thyristors 110 et 112. Les anodes des thyristors 110 et 112 sont connectées à un noeud commun 114 qui est mis à la masse. De façon similaire, un noeud commun 116 entre les résistances 104 et 106 est connecté aux gâchettes de thyristors 118 et 120.

En fonctionnement, une chute de tension aux bornes de la résistance appropriée 98, 100, 104, 106 déclenche le thyristor associé. Une telle chute de tension est provoquée par un courant circulant entre les conducteurs de pointe ou de bague et les bornes T1 ou R1. Par exemple, un courant circulant vers la gauche le long de la ligne de pointe provoque une chute de tension sur la résistance 100 qui déclenche le thyristor 112. Un courant circulant vers la droite sur la ligne de pointe provoque une chute de tension sur la résistance 98 qui déclenche le thyristor 110. De même, un courant circulant dans l'une ou l'autre direction le long de la ligne de bague déclenche le thyristor 118 ou 120.

Quand un thyristor est déclenché par un courant à travers sa résistance de commande, le courant est dérivé vers la masse. Ceci empêche le courant de circuler en direction ou à partir de l'équipement protégé. Une fois que la circulation de courant a cessé, ou a chuté suffisamment bas pour que la chute de tension en travers la résistance associée ne produise plus une tension suffisante pour faire conduire le thyristor, le thyristor se coupe et le circuit de protection revient à son état normal.

La figure 6B représente un circuit de protection contre une surcharge 122 qui fonctionne de façon similaire au circuit de la figure 6A. Au lieu d'être connectées à la masse, les anodes des thyristors 110, 112 sont connectées à un noeud commun 124 qui est lui-même connecté à la ligne de bague 14. De même, les anodes des thyristors 118, 120 sont connectées à un noeud commun 126 qui est lui-même connecté à la ligne de pointe 12.

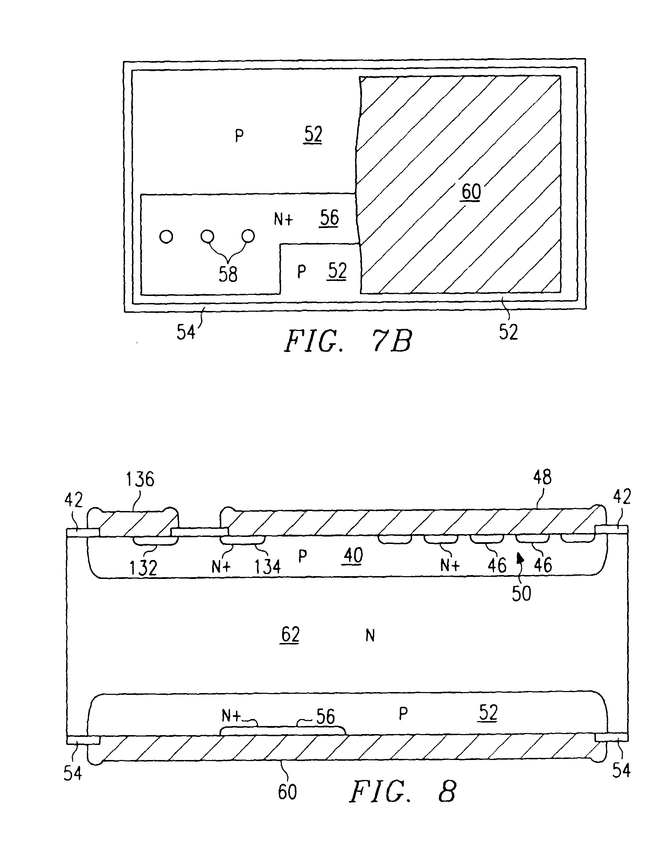

Les figures 7A et 7B correspondent au dispositif des figures 2A et 2B qui comprend en outre les circuits des figures 6A et 6B. La figure 7A représente une vue de dessus du dispositif et est similaire à la structure représentée en figure 2A. Des structures supplémentaires ont été formées dans les caissons P 38, 40. Ces structures sont des régions N⁺ 128, 130 dans le caisson P 38 et des régions N⁺ 132, 134 dans le caisson P 40.

Comme cela est représenté en figure 7A, le contact métallique 48 est modifié pour entrer en contact avec la région N⁺ 134 et pour ne pas contacter la région N⁺ 132. Un contact métallique séparé 136 établit un contact avec la région N⁺ 132. Le contact métallique 48 est utilisé pour établir une connexion avec le conducteur de pointe ou de bague du système téléphonique, tandis que le contact métallique 136 est utilisé pour établir un contact avec le conducteur de pointe ou de bague qui est relié à l'équipement à protéger. Comme dans le cas de la figure 2A, les contacts métalliques sur le caisson P 38 n'ont pas été représentés par souci de clarté.

La figure 7B représente la face arrière du dispositif. Comme cela est représenté, la région N⁺ 56 est rétrécie sous les dispositifs de thyristors.

La figure 8 est une vue en coupe selon la ligne A-A de la figure 7A. La figure 8 est similaire à la figure 3A avec l'adjonction des éléments de thyristors 132, 134, 136. Le thyristor 110 de la figure 6A est situé entre les métallisations 48 et 60. Le thyristor est constitué des régions 134, 40, 62 et 52. Le thyristor 112 de la figure 6A est situé entre les métallisations 136 et 60. Ce thyristor est constitué des régions 132, 40, 62 et 52. Ces deux thyristors ont une gâchette commune définie par la couche 40. Les résistances représentées en figures 6A et 6B correspondent au trajet de courant allant du contact métallique 48, en passant par le caisson P 40 sous les régions N⁺ 132, 134, vers le contact métallique 136. Le caisson P 40 agit comme gâchettes des thyristors.

Par symétrie, les régions 130, 38, 62 et 52 forment le thyristor 118 de la figure 6A et les régions 128, 38, 62 et 52 forment le thyristor 120 de la figure 6A. Le thyristor 110 de la figure 6B est représenté en figure 7A entre les deux métallisations principales supérieures, dont une seule est représentée. Ce thyristor est constitué des régions 130, 38, 62 et 40 et est un thyristor latéral. Le thyristor 112 de la figure 6B est constitué des régions 128, 38, 62 et 40. Par symétrie, il est possible de reconnaître en figure 7A les thyristors 118 et 120 de la figure 6B.

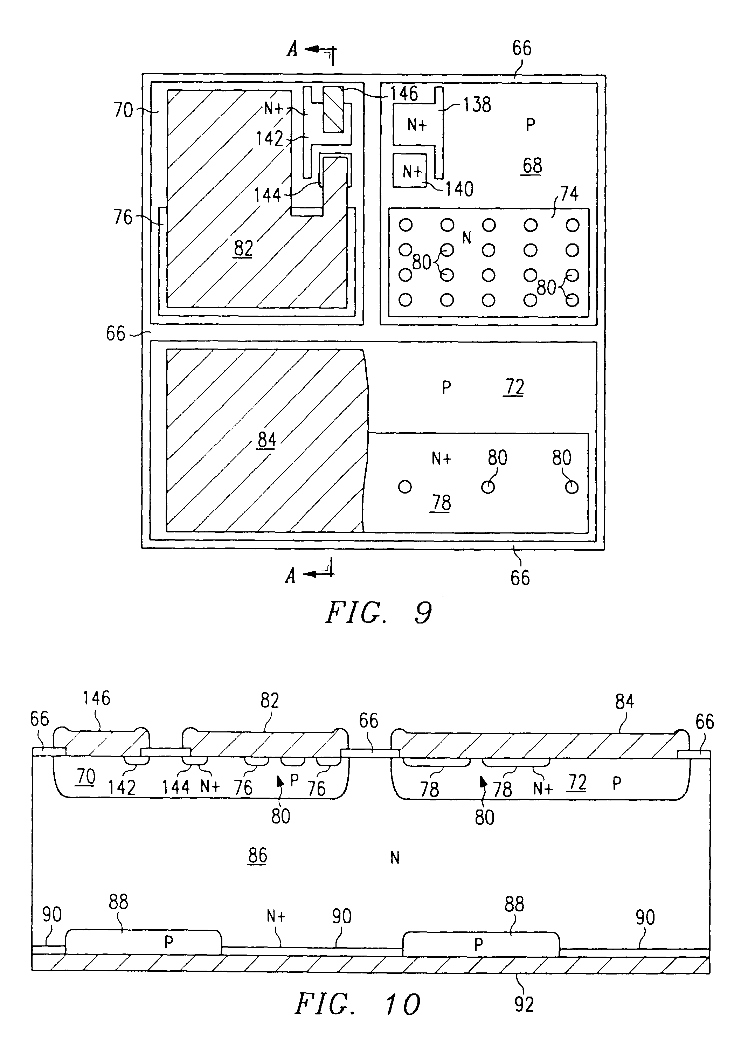

La figure 9 représente le circuit de protection en étoile de la figure 4 avec l'addition de circuits de protection à thyristors. En raison de la configuration différente de ce dispositif, ces thyristors mettent en oeuvre la connexion de pointe à bague représentée en figures 6A et 6B. L'orientation des diverses cellules a été modifiée par rapport à celle représentée en figure 4 mais les commutateurs PNPN bidirectionnels fonctionnent comme cela a été décrit précédemment.

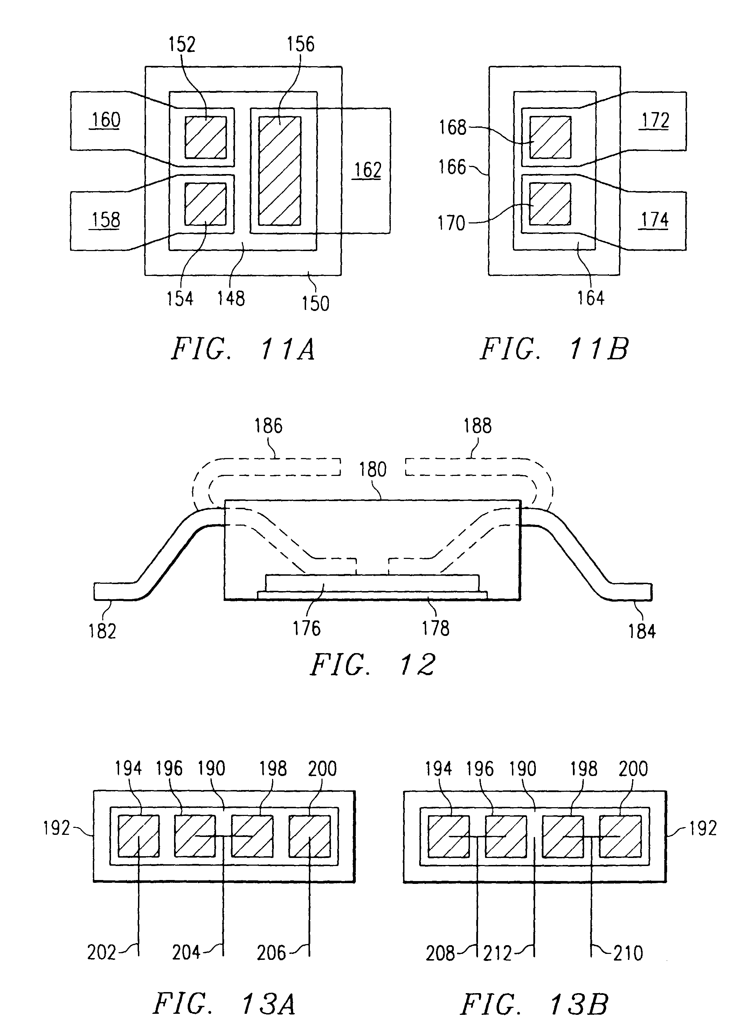

Des régions N⁺ 138, 140 sont formées de la façon représentée dans le caisson P 68. Des régions N⁺ 142, 144 sont formées de la façon représentée dans le caisson P 70. Comme dans le mode de réalisation précédent, le contact métallique 82 est modifié pour entrer en contact avec la région N⁺ 144. Un contact métallique 146 établit un contact avec la région N⁺ 142 et est utilisé pour être relié à l'équipement à protéger. La figure 10 est une vue en coupe du dispositif de la figure 9 prise selon la ligne A-A. Elle est similaire au dispositif représenté en figure 5 mais en rajoutant les éléments propres aux structures de thyristors. Les résistances représentées en figures 6A et 6B sont formées par le trajet dans le caisson P 70 entre le contact métallique 82 et le contact métallique 146. Comme précédemment, le caisson P 70 agit en tant que gâchette pour les thyristors. Le caisson P 88 sous-jacent au caisson P 70 a été élargi pour s'étendre sous les thyristors ainsi que sous la région N⁺ 76. Dans les parties du caisson P ne s'étendant pas sous les thyristors, la région de caisson P 88 s'étendra seulement sous la région N⁺ 76.

La figure 10 représente le thyristor 110 de la figure 6A disposé entre les métallisations 82 et 92. Ce thyristor est constitué des régions 144, 70, 86 et 88. Le thyristor 112 de la figure 6A est disposé entre les métallisations 146 et 92 et est constitué des régions 142, 70, 86 et 88. Ces deux thyristors ont une gâchette de commande commune définie par la couche 70. Les résistances représentées en figure 6B correspondent au trajet entre le contact métallique 82 à travers le caisson P 70, sous les régions N⁺ 142, 144, jusqu'au contact métallique 146.

En figure 9, par symétrie, le thyristor 118 de la figure 6A est constitué des régions 140, 68, 86 et 88. Le thyristor 120 de la figure 6A est constitué des régions 138, 68, 86 et 88. Le contact 92 (figure 10) est connecté au contact de masse 84 par une diode constituée par des régions 90, 86 et 72. Les thyristors 110, 112, 118 et 120 représentés en figure 6B sont formés en figure 9 exactement de la même façon qu'en figure 7A.

Les structures de puces décrites ci-dessus assurent de nombreux avantages en ce qui concerne la mise en boîtier des dispositifs achevés. Elles sont symétriques et plusieurs types de boîtiers peuvent être utilisés pour recevoir les puces contenant les circuits de protection.

La figure 11 représente une technique de montage préférée pour la structure de puce en étoile décrite en figure 4. Une puce semiconductrice 148 est formée selon la structure de la figure 4. La puce 148 est liée à un radiateur 150 qui peut être utilisé pour évacuer la chaleur du boîtier. Les contacts métalliques 152 et 154 sont utilisés pour établir une connexion avec les lignes de pointe et de bague et le contact métallique 156 est relié à la masse.

Les contacts sont liés à des conducteurs 158, 160, 162 en utilisant des techniques bien connues. Comme tout le circuit est contenu dans une seule puce, seulement trois conducteurs sont requis.

Si la puce 148 est un dispositif à 5 bornes, comme cela est décrit en relation avec la figure 9, deux conducteurs supplémentaires peuvent être prévus dans la grille de connexion et sont fixés aux emplacements appropriés sur la puce. A nouveau, ce boîtier est simple à fabriquer et le fait que tout les circuits sont contenus dans une seule puce simplifie la mise en boîtier et assure qu'un bon scellement hermétique peut être réalisé.

La figure 11B représente une structure de liaison similaire pour le dispositif de la figure 2. Comme le contact de masse est sur la face arrière de la puce, la surface de la puce 164 est inférieure à celle de la puce 148. Dans cet exemple, la puce 164 est liée à un radiateur conducteur 166 qui sert à évacuer la chaleur du dispositif et agit comme contact de masse. Dans un boîtier de ce type, le dispositif doit normalement être fixé à un radiateur externe mis à la masse. Les contacts métalliques 168, 170 sont reliés à des conducteurs 172, 174 qui sont eux-mêmes connectés aux conducteurs de pointe et de bague.

Comme cela est représenté en figure 11B, la structure présentant une connexion à la masse sur la face arrière du dispositif est beaucoup plus petite et peut présenter des avantages de mise en boîtier. Toutefois, cette structure nécessite qu'un conducteur ou autre connexion conductrice soit réalisé sur la face arrière du dispositif et nécessite que, si un radiateur est connecté au dispositif, ce radiateur soit mis à la masse. A titre de variante de la technique illustrée en figure 11B, un contact de masse peut être connecté à la face arrière du dispositif et s'étendre vers la droite de même que les conducteurs 172, 174.

La figure 12 représente une technique pour placer des dispositifs du type décrit dans un boîtier hermétiquement scellé. La puce semiconductrice 176 est liée à un radiateur 178. Si la configuration en triangle est mise en boîtier, le radiateur 178 conviendra pour une connexion à une structure mise à la masse.

Un boîtier 180 en plastique moulé par injection ou autre matériau convenable entoure la puce 176 et le radiateur 178. Des conducteurs 182 et 184 peuvent être fixés pour sortir des deux côtés du boîtier 180 ou peuvent sortir d'un seul côté comme cela est représenté en figure 11B. A partir du point d'où ils sortent du boîtier 180, les conducteurs peuvent rester horizontaux (non représenté) ou peuvent être courbés vers le bas pour faire contact à un emplacement coplanaire avec le fond du radiateur 178. A titre de variante, comme cela est représenté en pointillés par les références 186 et 188, les conducteurs peuvent être courbés pour former un boîtier à conducteurs en J comme cela est représenté.

Un avantage de la structure en étoile représentée en figure 4 est qu'elle peut facilement être reconfigurée pour fonctionner en tant que circuit de protection non équilibré tel que celui de la figure 1C. Ceci peut être réalisé sous forme d'une option de mise en boîtier sans modifier la topologie de la puce. Ceci est réalisé en modifiant l'agencement de conducteurs de la figure 11A pour qu'un seul conducteur large s'étende vers la gauche de façon identique au conducteur 162 qui s'étend vers la droite. Le conducteur combiné 158, 160 et le conducteur 162 peuvent alors être connectés entre les conducteurs de pointe et de bague du circuit. La borne commune sur la face du dispositif est liée à un radiateur conducteur 178 comme cela est représenté en figure 12. Ce radiateur conducteur est alors lui-même connecté à un radiateur mis à la masse ou connecté d'une autre manière au potentiel de la masse. Ainsi, le dispositif à configuration en étoile peut être converti en un dispositif à configuration déséquilibrée en utilisant la même puce.

Les figures 13A et 13B représentent une autre topologie pour le dispositif qui permet de réaliser diverses structures de protection en utilisant des options de liaison. En figure 13A, une puce semiconductrice 190 est liée à un radiateur 192. La puce comprend quatre régions 194, 196, 198, 200 qui peuvent être identiques. Chacune des régions 194 à 200 peut avoir la même topologie que l'un des caissons P contenus sur la face supérieure de la structure de puce de la figure 2. Ces quatre régions sont séparées par des régions d'oxyde et chacune comprend un contact métallique sur sa face supérieure.

Pour former un agencement en étoile, trois conducteurs 202, 204, 206 peuvent être liés à la puce 190 de la façon représentée. Le conducteur 202 est lié à la région 194 et le conducteur 206 est lié à la région 200. Le conducteur 204 est lié aux deux régions 196, 198 et de préférence un conducteur plus large à la façon du conducteur représenté en figure 11A. Le conducteur 204 convient alors pour une connexion à la masse, alors que les conducteurs 202 et 206 sont connectés aux conducteurs de pointe et de bague.

La figure 13B représente un mode de liaison pour la même puce 190 qui fournit une configuration en triangle. Avec ce type de liaison, les conducteurs 208 et 210 sont chacun reliés à deux des régions 194, 200. Ce radiateur 190 est conducteur, et un conducteur 212 est connecté à son radiateur. Il en résulte que l'agencement déséquilibré est représenté en figure 1C.

Comme le notera l'homme de l'art, les structures de puce et agencement de boîtier exposé précédemment fournissent un dispositif monolithique capable d'assurer une protection contre des surtensions pour des dispositifs tels que ceux liés à des lignes téléphoniques. Puisque ces structures utilisent un boîtier semiconducteur unique, elles peuvent être mises en boîtier de façon peu coûteuse tout en étant protégées sérieusement contre des conditions d'environnement difficiles. Divers types de boîtiers peuvent être utilisés pour une configuration de circuit intégré donné.

La présente invention est susceptible de nombreuses variantes et modifications qui apparaîtront à l'homme de l'art.

## Revendications

1. Circuit de protection contre des surtensions comprenant :
des première et deuxième régions (38, 40 ; 70, 72) formées dans un substrat (62 ; 86) ayant un premier type de conductivité, les première et deuxième régions ayant un second type de conductivité et ayant la même surface ;
des troisième et quatrième régions (44, 46 ; 74, 76) ayant le premier type de conductivité, formées dans les première et deuxième régions, respectivement, ces troisième et quatrième régions n'étant pas continues et comprenant des trous (50) dans lesquels des parties des première et deuxième régions, respectivement, sont exposées ;
une cinquième région (52 ; 72) formée dans le substrat et ayant le second type de conductivité et une surface sensiblement double de celle de la première région ;
une sixième région (56 ; 78) ayant le premier type de conductivité formée dans la cinquième région, cette sixième région n'étant également pas continue, et comprenant des trous (58) dans lesquels des parties de la cinquième région sont exposées, la densité de trous (58) dans cette sixième région étant au moins deux à trois fois inférieure à la densité de trous respective dans les troisième et quatrième régions ; et
des premier, deuxième et troisième contacts conducteurs (64, 48, 60 ; 82, 84, 92) connectés aux première, deuxième et cinquième régions, respectivement, le premier contact établissant également un contact avec la troisième région, le deuxième contact établissant également un contact avec la quatrième région et le troisième contact établissant également un contact avec la sixième région ;
dans lequel des commutateurs bidirectionnels sont formés entre chaque paire de contacts conducteurs.

2. Circuit de protection contre des surtensions selon la revendication 1, caractérisé en ce que la cinquième région est formée sur une surface du substrat opposée à celle des première et deuxième régions, d'où il résulte que les commutateurs bidirectionnels forment une configuration en triangle.

3. Circuit de protection contre des surtensions selon la revendication 1, caractérisé en ce que les première, deuxième et cinquième régions sont formées sur une même surface du substrat, d'où il résulte que les commutateurs bidirectionnels forment une configuration en triangle.

4. Circuit de protection contre des surtensions selon la revendication 3, caractérisé en ce qu'il comprend en outre un noeud commun conducteur formé sur une deuxième surface du substrat opposée à ladite même surface.

5. Circuit de protection contre des surtensions selon la revendication 4, caractérisé en ce que le noeud commun conducteur comprend une couche métallique (92) formée sur la deuxième surface du substrat.

6. Circuit de protection contre des surtensions selon la revendication 1, caractérisé en ce que le premier type de conductivité est le type N et le deuxième type de conductivité est le type P.

7. Circuit de protection contre des surtensions selon la revendication 1, caractérisé en ce qu'il comprend en outre :
des premier et deuxième détecteurs connectés électriquement aux premier et deuxième contacts pour détecter un passage de courant à travers les lignes de signal connectées aux premier et deuxième contacts ; et
des premier et deuxième circuits connectés auxdits détecteurs pour relier électriquement les premier et deuxième contacts ensemble quand la circulation de courant détectée dépasse un seuil choisi.

8. Circuit de protection contre des surtensions selon la revendication 7, caractérisé en ce que les premier et deuxième détecteurs comprennent des résistances.

9. Circuit de protection contre des surtensions selon la revendication 8, caractérisé en ce que les premier et deuxième circuits comprennent des thyristors.

10. Circuit de protection contre des surtensions selon la revendication 7, caractérisé en ce que les détecteurs et les circuits fonctionnent pour un courant circulant dans une première direction et comprennent en outre :
des troisième et quatrième détecteurs électriquement connectés aux premier et deuxième contacts pour détecter une circulation de courant dans les lignes de signal dans une seconde direction ; et
des troisième et quatrième circuits connectés aux troisième et quatrième détecteurs pour connecter électriquement les premier et deuxième contacts l'un à l'autre quand la circulation de courant détectée dans la seconde direction dépasse le seuil choisi.

11. Circuit de protection contre des surtensions selon la revendication 7 ou 10, caractérisé en ce que les détecteurs et les circuits sont formés dans lesdites première et deuxième régions, formant ainsi un circuit intégré monolithique.

12. Circuit de protection contre des surtensions selon la revendication 1, caractérisé en ce qu'il comprend en outre des conducteurs connectés aux premier, deuxième et troisième contacts.

13. Circuit de protection contre des surtensions selon la revendication 12, caractérisé en ce que les conducteurs s'étendent à l'extérieur d'un boîtier isolant contenant le substrat.

14. Circuit de protection contre des surtensions selon la revendication 1, caractérisé en ce qu'il comprend des conducteurs connectés aux premier et deuxième contacts et un radiateur connecté au troisième contact.

15. Circuit de protection contre des surtensions selon la revendication 4, caractérisé en ce que le noeud commun est connecté à un radiateur externe à un boîtier contenant le substrat.

16. Circuit de protection contre des surtensions selon la revendication 1, caractérisé en ce que les trous des troisième, quatrième et sixième régions sont circulaires.

## Patentansprüche

1. Überspannungsschutz-Schaltung, umfassend
in einem Substrat (62;86) eines ersten Leitfähigkeitstyps ausgebildete erste und zweite Bereiche (38,40; 70,20) eines zweiten Leitfähigkeitstyps mit derselben Oberfläche;
in den ersten bzw. zweiten Bereichen ausgebildete dritte bzw. vierte Bereiche (44,46; 74,76) des ersten Leitfähigkeitstyps, wobei diese dritten und vierten Bereiche nicht kontinuierlich sind und Löcher bzw. Öffnungen (50) umfassen, in welchen Teile der ersten bzw. zweiten Bereiche freiliegen ;
einen in dem Substrat ausgebildeten fünften Bereich (52;72) vom zweiten Leitfähigkeitstyp, der eine im wesentlichen doppelt so große Fläche wie der erste Bereich besitzt;
einen in dem fünften Bereich ausgebildeten sechsten Bereich (56;78) vom ersten Leitfähigkeitstyp, wobei dieser sechste Bereich gleichfalls nicht kontinuierlich ist und Löcher bzw. Öffnungen (58) umfaßt, in welchen Teile des fünften Bereichs freiliegen , wobei die Dichte der Löcher bzw. Öffnungen (58) in diesem sechsten Bereich wenigstens zwei- bis dreimal kleiner als die entsprechende Löcherdichte in den dritten und vierten Bereichen ist;
sowie mit dem ersten, zweiten bzw. fünften Bereich verbundene erste, zweite bzw. dritte leitende Kontakte (64,48, 60; 82,84,92), wobei der erste Kontakt gleichzeitig einen Kontakt mit dem dritten Bereich, der zweite Kontakt gleichzeitig einen Kontakt mit dem vierten Bereich, und der dritte Kontakt gleichzeitig einen Kontakt mit dem sechsten Bereich bilden;
wobei in der Schaltung bidirektionale Schalter jeweils zwischen jedem Paar von Leiterkontakten gebildet sind.

2. Überspannungsschutz-Schaltung nach Abspruch 1, dadurch gekennzeichnet, daß der fünfte Bereich auf einer der Oberfläche der ersten und zweiten Bereiche gegenüberliegenden Oberfläche des Substrats gebildet ist, derart daß die bidirektionalen Schalter eine Dreieck-Schaltungskonfiguration bilden.

3. Überspannungsschutz-Schaltung nach Anspruch 1, dadurch gekennzeichnet, daß der erste, zweite und fünfte Bereich auf ein und derselben Substratoberfläche ausgebildet sind, derart daß die bidirektionalen Schalter eine Sternschaltungs-Konfiguration bilden.

4. Überspannungsschutz-Schaltung nach Anspruch 3, dadurch gekennzeichnet, daß sie des weiteren einen gemeinsamen leitenden Knotenpunkt aufweist, der auf einer der genannten selben Oberfläche gegenüberliegenden Substratoberfläche ausgebildet ist.

5. Überspannungsschutz-Schaltung nach Anspruch 4, dadurch gekennzeichnet, daß der gemeinsame Leiterknotenpunkt eine auf der zweiten Substratoberfläche ausgebildete Metallschicht (92) aufweist.

6. Überspannungsschutz-Schaltung nach Anspruch 1, dadurch gekennzeichnet, daß der erste Leitfähigkeitstyp N-Leitfähigkeit und der zweite Leitfähigkeitstyp P-Leitfähigkeit ist.

7. Überspannungsschutz-Schaltung nach Anspruch 1, dadurch gekennzeichnet, daß sie des weiteren umfaßt:
mit den ersten und zweiten Kontakten elektrisch verbundene erste und zweite Detektoren zum Nachweis eines Stromflußes in den mit den ersten und zweiten Kontakten verbundenen Signalleitungen;
mit den genannten Detektoren verbundene erste und zweite Schaltungen, welche die ersten und zweiten Kontakte miteinander verbinden, wenn der nachgewiesene Stromfluß einen gewählten Schwellwert übersteigt.

8. Überspannungsschutz-Schaltung nach Anspruch 7, dadurch gekennzeichnet, daß die ersten und zweiten Detektoren Widerstände aufweisen.

9. Überspannungsschutz-Schaltung nach Anspruch 8, dadurch gekennzeichnet, daß die ersten und zweiten Schaltungen Thyristoren umfassen.

10. Überspannungsschutz-Schaltung nach Anspruch 7, dadurch gekennzeichnet, daß die Detektoren und die Schaltungen für einen in einer ersten Richtung fließenden Strom wirksam sind und des weiteren umfassen:
mit den ersten und zweiten Kontakten elektrisch verbundene dritte und vierte Detektoren zum Nachweis eines in den Signalleitungen in einer zweiten Richtung fließenden Stroms;
mit den dritten und vierten Detektoren verbundene dritte und vierte Schaltungen, welche die ersten und zweiten Kontakte miteinander verbinden, sobald der in der zweiten Stromrichtung nachgewiesene Stromfluß den gewählten Schwellwert übersteigt.

11. Überspannungsschutz-Schaltung nach Anspruch 7 oder 10, dadurch gekennzeichnet, daß die Detektoren und die Schaltungen in den genannten ersten und zweiten Bereichen ausgebildet sind und so eine monolithische integrierte Schaltung bilden.

12. Überspannungsschutz-Schaltung nach Anspruch 1, dadurch gekennzeichnet, daß sie des weiteren mit den ersten, zweiten und dritten Kontakten verbundene Leiter umfaßt.

13. Überspannungsschutz-Schaltung nach Anspruch 12, dadurch gekennzeichnet, daß die Leiter sich aus einem das Substrat enthaltenden isolierenden Gehäuse heraus nach außen erstrecken.

14. Überspannungsschutz-Schaltung nach Anspruch 1, dadurch gekennzeichnet, daß sie mit den ersten und zweiten Kontakten verbundene Leiter sowie eine mit dem dritten Kontakt verbundene Wärmesenke umfaßt.

15. Überspannungsschutz-Schaltung nach Anspruch 4, dadurch gekennzeichnet, daß der gemeinsame Knotenpunkt mit einer Wärmesenke außerhalb des das Substrat enthaltenden Gehäuses verbunden ist.

16. Überspannungsschutz-Schaltung nach Anspruch 1, dadurch gekennzeichnet, daß die Löcher bzw. Öffnungen der dritten, vierten und sechsten Bereiche kreisförmig sind.

## Claims

1. An overvoltage protection circuit, comprising:
first and second regions (38, 40; 70, 72), formed within a substrate (62; 86) having a first conductivity type, said first and second regions having a second conductivity type and having the same surface area;
third and fourth regions (44, 46; 74, 76), having the first conductivity type, formed within said first and second regions, respectively, wherein said third and fourth regions are not continuous and including holes (50) through which portions of said first and second regions, respectively, are exposed;
a fifth region (52; 72), formed within the substrate, having the second conductivity type and having an area approximately twice that of said first region;
a sixth region (56; 78), having the first conductivity type, formed within said fifth region, wherein said sixth region is also not continuous and including holes (58) through which portions of said fifth region are exposed, and wherein the hole density (58) in said sixth region is at least two-three times less than the respective hole density within the third and fourth regions; and
first, second and third conductive contacts (64, 48, 60; 82, 84, 92) connected to said first, second, and fifth regions, respectively, said first contact also contacting said third region, said second contact also contacting said fourth region, and said third contact also contacting said sixth region;
wherein bidirectional switches are formed between each pair of said conductive contacts.

2. The overvoltage protection circuit of claim 1, characterized in that said fifth region is formed on a surface of the substrate opposite that of said first and second regions, whereby the bidirectional switches form a delta configuration.

3. The overvoltage protection circuit of claim 1, characterized in that said first, second, and fifth regions are formed on a single surface of the substrate, whereby the bidirectional switches form a star configuration.

4. The overvoltage protection circuit of claim 3, characterized in that it further comprises a conductive common node formed on a second surface of the substrate opposite the single surface.

5. The overvoltage protection circuit of claim 4, characterized in that said conductive common node comprises a metal layer formed on the second substrate surface.

6. The overvoltage protection circuit of claim 1, characterized in that the first conductivity type is N-type, and the second conductivity type is P-type.

7. The overvoltage protection circuit of claim 1, characterized in that it further comprises:
first and second sensors electrically connected to said first and second contacts for sensing current flow through signal lines connected to said first and second contacts; and
first and second circuits, connected to said sensors, for electrically connecting the first and second contacts together when the sensed current flow surpasses a selected level.

8. The overvoltage protection circuit of claim 7, characterized in that said first and second sensors comprise resistors.

9. The overvoltage protection circuit of claim 8, characterized in that said first and second circuits comprise thyristors.

10. The overvoltage protection circuit of claim 7, characterized in that said sensors and circuits operate for current flowing in a first direction, and further comprise:
third and fourth sensors electrically connected to said first and second contacts for sensing current flow through the signal lines in a second direction; and
third and fourth circuits, connected to said third and fourth sensors, for electrically connecting the first and second contacts together when the sensed current flow in the second direction surpasses the selected level.

11. The overvoltage protection circuit of Claim 7 or 10, characterized in that said sensors and said circuits are formed within said first and second regions, thereby forming a monolithic integrated circuit.

12. The overvoltage protection circuit of claim 1, characterized in that it further comprises leads connected to said first, second, and third contacts.

13. The overvoltage protection circuit of claim 12, characterized in that said leads extend externally of an insulating package containing the substrate.

14. The overvoltage protection circuit of claim 1, characterized in that it further comprises leads connected to said first and second contacts, and a heat sink connected to said third contact.

15. The overvoltage protection circuit of claim 4, characterized in that the conductive common node is connected to a heat sink external of a package containing the substrate.

16. The overvoltage protection circuit of claim 1, characterized in that the holes in said third, fourth, and sixth regions are circular.
